Europäisches Patentamt

(19) European Patent Office

Office européen des brevets

(11) Numéro de publication: **0 163 581 B1**

(12) **FASCICULE DE BREVET EUROPEEN**

(45) Date de publication du fascicule du brevet:
24.05.89

(21) Numéro de dépôt: 85401071.7

(22) Date de dépôt: 30.05.85

(51) Int. Cl.⁴: **H 05 K 3/36**, H 05 K 1/14,
H 05 K 3/02

(54) Procédé de réalisation d'un dispositif de raccordement électrique entre deux cartes de circuits imprimés, dispositif ainsi obtenu, et procédé de raccordement électrique mettant en oeuvre ce dispositif.

(30) Priorité: 30.05.84 FR 8408494

(43) Date de publication de la demande:
04.12.85 Bulletin 85/49

(45) Mention de la délivrance du brevet:
24.05.89 Bulletin 89/21

(84) Etats contractants désignés:
DE GB IT NL SE

(56) Documents cités:
FR-A- 2 135 736
FR-A- 2 356 247
US-A- 3 221 286
US-A- 4 268 956

SID INTERNATIONAL SYMPOSIUM DIGEST OF
TECHNICAL PAPERS, avril 1980, édition 1, pages 70-71,
Coral Gables, Florida, US; R.D. KETCHPEL et al.: "High
density interconnect for high resolution EL video
display"
PROCEEDINGS OF THE SID, vol. 21/2, 1980, pages
157-164, Los Angeles, US; L.S. BUCHOFF:
"Metal-elastomeric display connectors"

(73) Titulaire: THOMSON-CSF, 51, Esplanade du Général de
Gaulle, F-92800 Puteaux (FR)

(72) Inventeur: Dezon, Lucien, THOMSON-CSF SCPI 173, bld
Haussmann, F-75379 Paris Cedex 08 (FR)

(74) Mandataire: Benoit, Monique et al, THOMSON-CSF
SCPI, F-92045 PARIS LA DEFENSE CEDEX 67 (FR)

## Description

La présente invention concerne un dispositif de raccordement électrique entre deux cartes de circuits imprimés et son procédé de réalisation, ainsi qu'un procédé de raccordement électrique de deux cartes de circuits imprimés à l'aide d'un tel dispositif.

Le problème technique que cherche à résoudre l'invention est celui du raccordement électrique de deux cartes de circuits imprimés, équipées ou non de composants, et réalisées à partir soit de supports dits classiques, du type verre-époxy, Kapton® ou autre, soit de supports dits stables du type céramique (par exemple alumine), lorsque ces cartes sont «haute densité» c'est-à-dire présentent un très grand nombre de connexions de sortie, disposées selon un pas très serré. Ainsi qu'il est connu, ces derniers supports en céramique sont plus stables en température que les supports classiques, autrement dit se dilatent peu sous l'effet de la chaleur; ils sont avantageusement utilisés dans les matériels militaires où ils sont soumis à d'importantes variations de température; en outre, ils présentent l'avantage de varier en dimensions dans le même sens et les mêmes proportions que les composants du type «chip-carrier» qu'ils supportent, puisqu'ils sont réalisés dans le même matériau.

Actuellement, il existe différents types de dispositifs de raccordement électrique entre deux cartes de circuits imprimés haute densité. Un premier type de dispositif est réalisé à partir d'un circuit souple, constitué de connexions métalliques disposées entre deux couches de substrat isolant souple, du genre Kapton®, équipé à ses extrémités de connecteurs à broches, enfichables dans des trous métallisés réalisés dans les cartes à raccorder. Ce premier type de dispositif présente l'inconvénient d'être encombrant et onéreux. En outre, il est incompatible avec les raccordements sur des cartes réalisées à partir d'un support en alumine: en effet, l'alumine étant très fragile, le support risque de se briser lors du perçage des trous. De plus, il n'est pas possible de métalliser des trous percés dans l'épaisseur de cartes en céramique. Un second type de dispositif de raccordement utilise des fils qui doivent être soudés l'un après l'autre. Cette méthode permet de réaliser des raccordements entre des cartes de circuits imprimés à haute densité, faites à partir de supports stables, en céramique. Cependant cette méthode par soudage fil à fil présente l'inconvénient d'être délicate, longue et onéreuse; de plus les connexions ainsi faites sont fragiles.

Il est connu du document US-4 268 956 de réaliser un câble d'interconnexion de la façon suivante:

– dans une première étape sont fixées l'une à l'autre une feuille de cuivre et une feuille de matériau isolant dans laquelle des ouvertures ont été prévues;

– dans une deuxième étape, du cuivre est déposé dans les ouvertures précédentes pour être en contact électrique avec la feuille de cuivre;

– dans une troisième étape, des premiers contacts en or sont déposés sur le cuivre de la deuxième étape, et des deuxièmes contacts en or sont déposés sur la feuille de cuivre, au niveau des premiers contacts;

– dans une quatrième étape, la feuille de cuivre est gravée pour former les connexions désirées.

La présente invention a pour but de pallier ces divers inconvénients pour permettre la réalisation de raccordements électriques entre des cartes de circuits imprimés, équipées ou non de composants, réalisées à partir de supports classiques ou stables et à haute densité de connexions de sortie. A cet effet, le dispositif selon l'invention comporte au moins deux substrats isolants percés à leurs extrémités, entre lesquelles sont déposées des rubans conducteurs visant à constituer des connexions électriques.

Plus précisément, l'objet de la présente invention est tout d'abord un procédé de réalisation d'un dispositif de raccordement électrique entre deux cartes de circuits imprimés, tel que défini par la revendication 1. L'invention a également pour objet le dispositif obtenu par le procédé précédent, tel que défini par la revendication 11, ainsi qu'un procédé de raccordement électrique entre deux cartes de circuits imprimés, réalisé à partir du dispositif précédent. Les avantages de l'invention sont, entre autres, les suivants: le raccordement électrique s'effectue dans un emplacement réduit; les liaisons sont très souples et légères, et le nombre de connexions à raccorder électriquement peut être plus grand.

D'autres particularités et avantages de l'invention apparaîtront dans la description qui suit, illustrée par les figures suivantes qui représentent:

– la figure 1: les différentes étapes d'un premier procédé de réalisation du dispositif de raccordement selon l'invention;

– la figure 2: une vue de dessus du dispositif selon l'invention;

– la figure 3: les différentes étapes d'un second procédé de réalisation d'un dispositif de raccordement selon l'invention;

– la figure 4: une variante du dispositif de raccordement selon l'invention;

– la figure 5: une vue en coupe transversale de deux cartes de circuits imprimés raccordées par le dispositif selon l'invention. Les éléments assurant les mêmes fonctions en vue des mêmes résultats sont référencés identiquement dans les différentes figures.

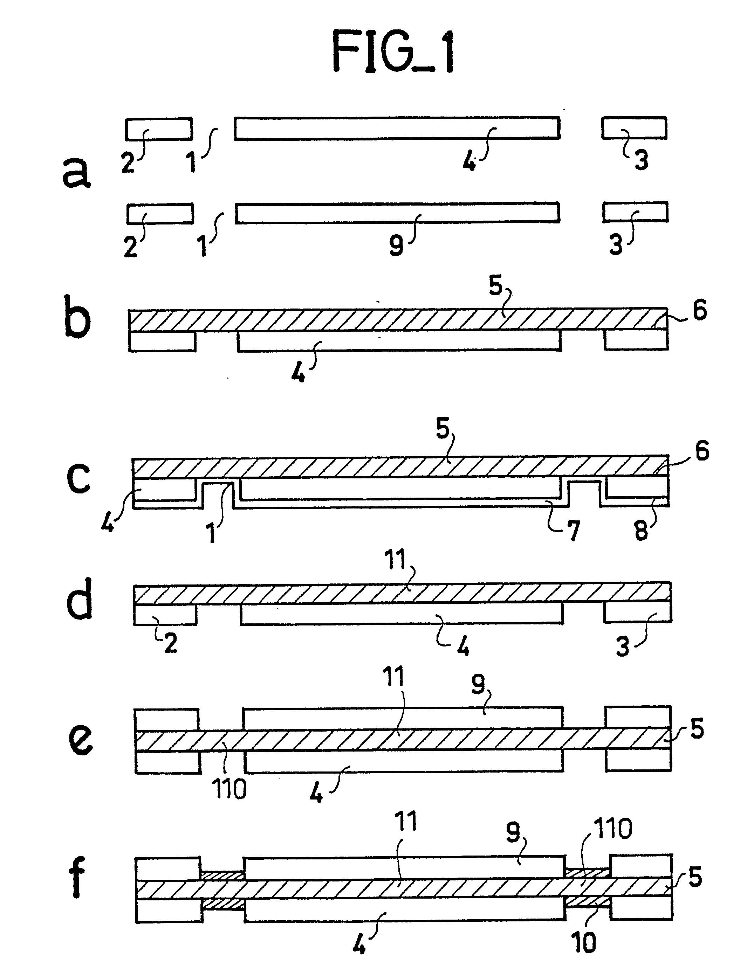

Le procédé de réalisation selon l'invention d'un dispositif de raccordement électrique entre deux cartes de circuits imprimés, qu'elles soient constituées à partir d'un support classique, de type Kapton ou d'un support stable du type alumine, comporte les étapes suivantes, représentées sur la figure 1:

– une première étape de perçage de deux substrats isolants 4 et 9, aux mêmes endroits, à leurs deux extrémités, comme le montre la figure 1a. Les ouvertures 1 percées aux extrémités 2 et 3 de chacun des substrats sont de formes diverses, plus particulièrement en forme de fente de longueur sensiblement égale à la largeur de chaque substrat, quand ces substrats sont de forme rectangulaire. Ces ouvertures 1 peuvent être également de forme circulaire, disposées selon deux lignes parallèles à la largeur du substrat et placées alternativement;

– une deuxième étape de dépôt d'une couche de matériau conducteur 5 (du cuivre par exemple) sur toute une première face (6) d'un des deux substrats, 4 par exemple, notamment sur les ouvertures 1 (figure 1b);

– une troisième étape, dans un mode de réalisation préféré, de dépôt d'une couche 7 de matériau protecteur sur la seconde face (8) du substrat opposée à la première face 6, ainsi que dans les ouvertures 1 pratiquées dans ce substrat. Ce matériau protecteur est par exemple du Vacrel, (marque déposée), insoluble à l'acide. Il est destiné à protéger la couche de matériau conducteur 5 dans l'étape suivante (figure 1c);

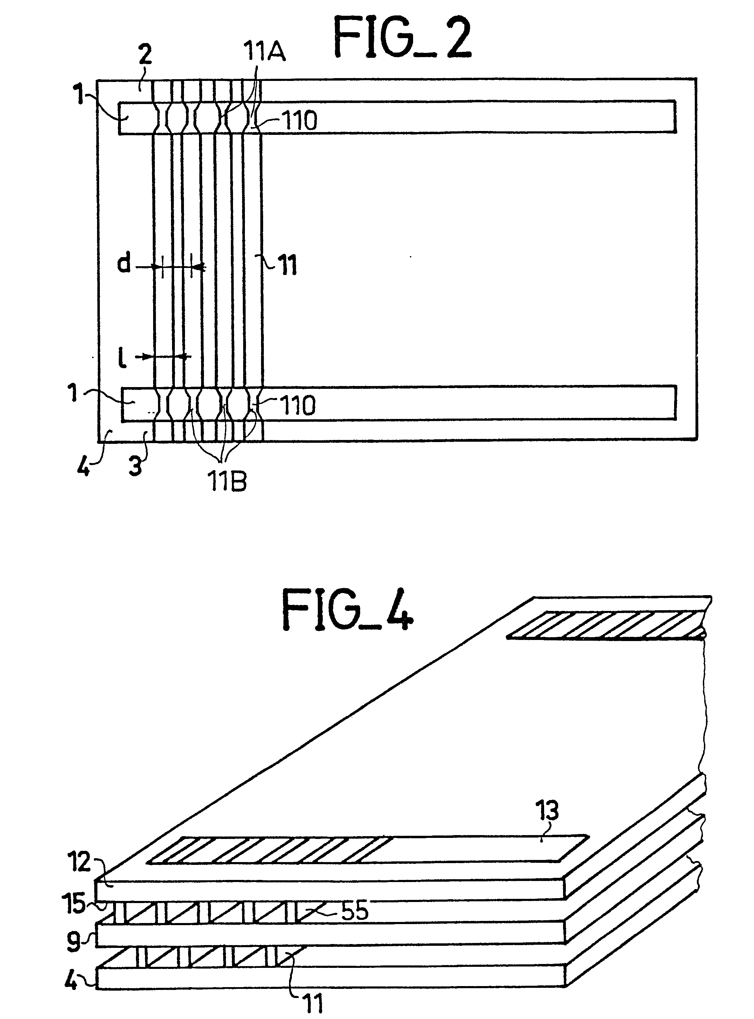

– une quatrième étape de gravure de pistes électriques formant connexions à partir de la couche de matériau conducteur 5. Il s'agit par un procédé de gravure classique, tel que la photogravure, de réaliser des connexions en forme de rubans (11) sensiblement parallèles disposés selon un pas d déterminé (figure 2). Dans un procédé de photogravure, il y a une étape d'attaque chimique par un acide et la couche protectrice 7 déposée à l'étape précédente a pour but d'éviter une attaque chimique des rubans sur leur face inférieure en regard des ouvertures 1;

– une cinquième étape de retrait, ou «stripage», par un solvant de la couche 7 de matériau protecteur, devenue inutile après la gravure des connexions (figure 1d);

– une sixième étape de fixation du second substrat isolant (9) sur les connexions gravées (11), avec mise en coïncidence des ouvertures 1 de deux substrats 4 et 9. Au niveau des ouvertures 1, les connexions électriques (11) sont totalement mises à nu (figure 1e);

– dans un mode de réalisation préféré, une septième étape d'étamage (couche 10) des zones 110 où les connexions électriques (11) sont dénudées sans support isolant, de façon à les préparer à l'étape de connexion sur une carte de circuit imprimé (figure 1f). Cet étamage permet également d'éviter l'oxydation du cuivre constituant les connexions 11.

Le dispositif de raccordement électrique obtenu par le procédé précédemment décrit est représenté par la figure 2, sur laquelle les substrats 4 et 9 sont rectangulaires et les ouvertures 1 sont en forme de fente. Les connexions électriques 11 sont réalisées en forme de rubans parallèles placés à pas déterminé d. Sur cette figure 2, la largeur l des rubans 11 est constante entre les deux ouvertures mais décroît au niveau des ouvertures. La largeur l est maximum dans la zone où le dispositif de raccordement est susceptible de subir une déformation très prononcée mais elle est minimum dans la zone de raccordement 110, au niveau des ouvertures 1 de façon à permettre la réalisation de soudure de qualité.

Il apparaît ainsi que le dispositif de raccordement selon l'invention présente deux séries (11A et 11B) de zones de raccordement (110) conductrices, sur lesquelles il est possible de connecter à plat par soudure les points de connexion de (respectivement) deux cartes de circuits imprimés. En outre, le pas (d) des zones de raccordement peut être très petit. En effet, les rubans 11 sont maintenus par les deux substrats 4 et 9 parallèlement les uns aux autres sur toute leur longueur de part et d'autre de la zone de raccordement (110), et le pas d ne dépend alors que des techniques de fabrication des rubans 11 (photogravure dans l'exemple décrit) et non de la fragilité des fils conducteurs comme dans la technique antérieure.

Ainsi, le dispositif selon l'invention est particulièrement adapté aux cartes de circuits imprimés haute densité.

Selon l'invention, il existe un second procédé de réalisation d'un dispositif de raccordement électrique entre deux cartes de circuits imprimés, réalisé à partir de trois couches de matériau isolant et de deux couches de matériau conducteur.

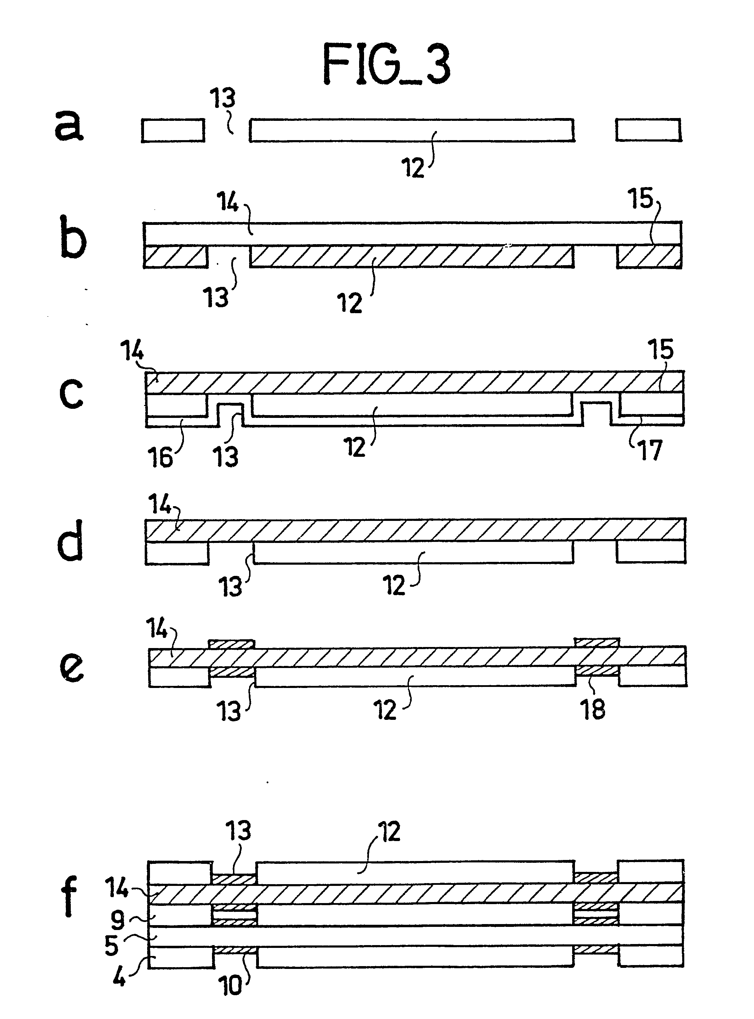

Ce procédé comporte de préférence les sept premières étapes du procédé précédent et comporte de plus les étapes suivantes, représentées sur la figure 3:

– une huitième étape de perçage des deux extrémités d'un troisième substrat isolant 12, aux mêmes endroits que les deux premiers substrats isolants 4 et 9 (figure 3a). Les ouvertures 13 percées aux extrémités ont sensiblement la même forme que celles percées dans les autres substrats 4 et 9;

– une neuvième étape de dépôt d'une couche 14 de matériau conducteur sur toute une première face 15 du substrat 12, notamment au niveau des ouvertures 13 (figure 3b);

– dans un mode de réalisation préféré, une dixième étape de dépôt d'une couche 16 de matériau protecteur sur une seconde face 17 du substrat 12 opposée à la première (15), ainsi que dans les ouvertures 13 pratiquées dans le substrat (figure 3c);

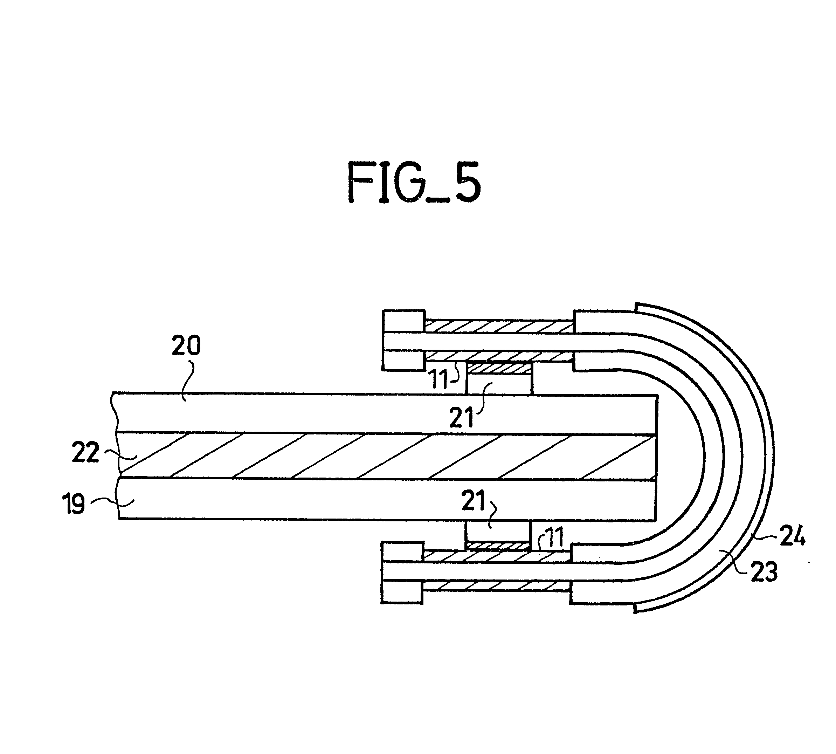

– une onzième étape de gravure de connexions électriques à partir de la couche conductrice 14. Ces connexions sont en forme de rubans sensiblement parallèles disposés de préférence selon le même pas d déterminé que celui séparant les connexions du dispositif obtenu par le précédent procédé (figure 4);

– une douzième étape de retrait ou «stripage» par un solvant de la couche protectrice 16 (figure 3d);

– une treizième étape d'étamage (couches 18) des zones où les connexions sont dénudées, sans support isolant (figure 3e);

– une quatorzième étape de dépôt des connexions portées par le troisième substrat isolant 12, avec mise en coïncidence des ouvertures 13 et 1, sur le second substrat 9 du premier dispositif obtenu par le précédent procédé, les connexions électriques étant disposées parallèlement à celles de ce premier dispositif mais de façon décalée (figure 3f et figure 4). Ainsi entre deux connexions du premier dispositif est placée une connexion du dernier dispositif.

Le dispositif de raccordement électrique obtenu par ce second procédé est représenté sur la figure 4.

Il comporte les trois substrats isolants 4, 9 et 12 entre lesquels sont disposées des connexions électriques qui sont parallèles entre elles. Les connexions placées entre les couches de substrat 12 et 9 repérées 55, sont décalées par rapport aux connexions placées entre les couches de substrat 9 et 4, d'une distance égale par exemple à la moitié du pas d.

Comme pour le procédé précédemment décrit, le dispositif obtenu est réalisé à partir de trois couches du type Kapton et à partir de deux couches de cuivre par exemple. Les différentes étapes de dépôt qui ont été mentionnées dans les procédés précédents sont par exemple réalisées par pressage à chaud. Quand aux étapes d'étamage, elles consisten en un dépôt d'étain-plomb par électrolyse, par exemple.

Selon une variante de l'invention, les connexions électriques obtenues lors de la onzième étape sont constituées par un plan conducteur au niveau du substrat 12 et par des rubans parallèles à pas constant, de largeur l déterminée, au niveau des ouvertures 13 percées dans le substrat 12.

Ce dernier mode de réalisation permet, par l'intermédiaire du plan conducteur raccordé à la masse, de blinder les connexions situées sur la couche en regard. Ce plan de masse permet également de véhiculer des courants importants et facilite au besoin le préformage du circuit.

La présente invention concerne également un procédé de raccordement électrique entre deux cartes de circuits imprimés au moyen d'un dispositif obtenu selon l'un des procédés décrits précédemment.

Chaque carte à raccorder comprend au moins un plot de connexion, en réalité une pluralité de plots. Le procédé de raccordement comprend une première étape de mise en coïncidence des plots des cartes de circuits imprimés avec les connexions (11, 55) du dispositif de raccordement, puis une deuxième étape de connexion électrique, par brasage par exemple, des connexions avec les plots; ce brasage est réalisé par exemple par fusion de l'étain-plomb recouvrant les connexions et les plots.

Sur la figure 5 sont représentées deux cartes de circuits imprimés 19 et 20, placées parallèlement et séparées par exemple par un drain thermique 22, dont le rôle est d'évacuer vers l'extérieur des circuits la chaleur provenant des composants en fonction. Chacune de ces cartes 19 et 20 comporte une pluralité de plots 21 de connexion alignés à une des extrémités de chaque carte. Ces cartes sont connectées au moyen d'un dispositif de raccordement électrique selon l'invention. Les connexions 11 des deux extrémités du dispositif de raccordement sont soudées aux plots 21, la partie centrale 23 du dispositif s'adaptant à l'extrémité des deux cartes à raccorder. Pour faciliter la pose du dispositif de raccordement sur les cartes, il peut être utile de déposer, sur une des couches externes de substrat isolant, une couche 24 d'un matériau rigide préformé, destinée à donner au dispositif une forme déterminée s'adaptant le mieux possible à la configuration des cartes à raccorder. Ce matériau rigide peut être par exemple du cuivre recuit. Cette forme peut être en arc de cercle ou en U par exemple.

A titre d'exemple pratique non limitatif, les différentes couches d'un dispositif de raccordement électrique selon l'invention ont les épaisseurs suivantes: de 15 à 25 microns pour les substrats isolants, de 17 à 35 microns pour les couches de matériau conducteur et de 17 à 35 microns pour la couche de matériau rigide préformée.

Le raccordement électrique de deux cartes de circuits imprimés selon l'invention s'effectue dans un emplacement réduit et les liaisons souples et légères ne nécessitent pas de fixation mécanique autre que celles réalisées par les soudures. Le fait que les connexions du dispositif de raccordement soient dénudées au niveau des soudures permet d'effectuer sur celles-ci un contrôle efficace. Enfin, un important avantage offert par l'invention réside dans la possibilité de connecter électriquement des cartes présentant une haute densité de connexions de sortie, le pas de celles-ci pouvant être égal à 0,508 mm, ce que les méthodes connues ne permettaient pas. Les connexions du dispositif de raccordement selon l'invention évitent tout risque de court-circuit puisqu'elles sont maintenues parallèles entre elles par les extrémités des substrats isolants.

L'invention n'est pas bien entendu limitée aux modes de réalisation décrits et représentés. Elle comprend également tous les équivalents techniques des moyens décrits ainsi que leurs combinaisons, si celles-ci sont mises en œuvre dans le cadre des revendications qui suivent.

**Revendications**

1. Procédé de réalisation d'un dispositif de raccordement électrique entre deux cartes de circuits imprimés, ledit procédé comportant les étapes suivantes:
   – une première étape de perçage d'ouvertures (1) dans au moins deux substrats isolants (4 et 9) à leurs deux extrémités (2 et 3), sensiblement aux mêmes endroits;
   – une deuxième étape de dépôt d'au moins une couche de matériau conducteur (5) sur toute une première face (6) du premier des substrats (4), y compris les ouvertures (1);
   – une troisième étape de gravure, à partir de la couche de matériau conducteur (5), de connexions électriques (11) sensiblement parallèles;
   – une quatrième étape de fixation du deuxième substrat (9) sur les connexions (11) gravées, avec mise sensiblement en coïncidence des ouvertures (1) des deux substrats (4 et 9), définissant ainsi des zones (110) où les connexions (11) sont mises à nu.

2. Procédé selon la revendication 1, caractérisé par le fait qu'il comporte en outre:

– entre les deuxième et troisième étapes, une première étape supplémentaire de dépôt d'une couche de matériau protecteur (7), sur une seconde face (8) du premier substrat opposée à la première face (6), ainsi que dans les ouvertures (1) pratiquées dans ce substrat;

– entre les troisième et quatrième étapes, une deuxième étape supplémentaire de retrait, par un solvant, de la couche de matériau protecteur (7);

3. Procédé selon l'une des revendications précédentes, caractérisé par le fait qu'il comporte en outre, après la quatrième étape, une étape d'étamage des zones (110) où les connexions (11) sont dénudées.

4. Procédé selon l'une des revendications précédentes, réalisé à partir de trois substrats isolants et de deux couches de matériau conducteur, caractérisé par le fait qu'il comporte de plus les étapes suivantes:

– une cinquième étape de perçage d'ouvertures (13) aux extrémités du troisième substrat (12) sensiblement aux mêmes endroits que les deux premiers substrats (4, 9);

– une sixième étape de dépôt d'une couche (14) de matériau conducteur sur toute une première face (5) du troisième substrat (12);

– une septième étape de gravure, à partir de la couche conductrice (14), de connexions électriques sensiblement parallèles (55);

– une huitième étape de fixation des connexions portées par le troisième substrat (12) sur le deuxième substrat (9), avec mise sensiblement en coïncidence des ouvertures des deuxième et troisième substrats.

5. Procédé selon la revendication 4, caractérisé par le fait qu'il comporte en outre:

– entre les sixième et septième étapes, une étape supplémentaire de dépôt d'une couche de matériau protecteur (16), sur une seconde face (17) du troisième substrat (12) opposée à la première (15) ainsi que dans les ouvertures (13) pratiquées dans ce substrat;

– entre les septième et huitième étapes, une étape supplémentaire de retrait, par un solvant, de la couche de matériau protecteur (16).

6. Procédé selon l'une des revendications 4 ou 5, caractérisé par le fait qu'il comporte en outre, avant la huitième étape, une étape d'étamage (18) des zones où les connexions sont dénudées.

7. Procédé selon les revendications 1 et 4, caractérisé par le fait que les connexions (11) portées par le premier substrat (4) sont placées parallèlement les unes aux autres, à pas donné, et que les connexions (55) portées par le troisième substrat sont placées parallèlement les unes aux autres au même pas que les précédentes et disposées en alternances par rapport aux précédentes.

8. Procédé selon l'une des revendications précédentes, caractérisé par le fait que les connexions électriques sont constituées par des rubans parallèles.

9. Procédé selon la revendication 8, caractérisé par le fait que les rubans parallèles sont de largeur (1) variable, décroissant au niveau des ouvertures (1).

10. Procédé selon la revendication 4, caractérisé par le fait que les connexions obtenues par la septième étape sont constituées par un plan conducteur au niveau du substrat isolant (12) et par des rubans parallèles au niveau des ouvertures (13).

11. Dispositif de raccordement électrique entre deux cartes de circuits imprimés, comportant un premier substrat isolant (4) comportant des ouvertures (1) et une couche de matériau conducteur (5) fixée sur le premier substrat isolant, ladite couche couvrant les ouvertures (1), des connexions électriques (11) sensiblement parallèles étant découpées dans la couche de matériau conducteur; le dispositif étant caractérisé par le fait qu'il comporte en outre un deuxième substrat isolant (9) comportant à ses deux extrémités des ouvertures, disposé sur la couche de matériau conducteur de sorte que les ouvertures des deux substrats soient sensiblement en coïncidence, définissant ainsi des zones (110) où les connexions (11) sont mises à nu.

12. Dispositif selon la revendications 11, caractérisé par le fait qu'il comporte en outre une couche de matériau rigide (24) préformée, déposée sur une des faces externes de substrat isolant, destinée à donner une forme prédéterminée au dispositif.

13. Dispositif selon la revendication 11, caractérisé par le fait que les substrats isolants sont constitués par un polyimide.

14. Dispositif selon la revendication 12, caractérisé par le fait que la couche de matériau rigide (24) préformée est en cuivre recuit.

15. Procédé de raccordement électrique entre deux cartes de circuits imprimés, chacune des cartes comportant une pluralité de plots de connexions, au moyen d'un dispositif de raccordement électrique selon l'une des revendications 11 à 14, caractérisé par le fait qu'il comporte:

– une première étape de mise en coïncidence des plots (21) des cartes (19, 20) avec les zones où les connexions (11) du dispositif de connexion sont mises à nu;

– une deuxième étape de connexion électrique par brasage des connexions avec les plots.

**Claims**

1. A method of producing a device for the electrical interconnection between two printed circuit boards, comprising the following steps:

– a first step of piercing openings (1) into at least two insulating substrates (4 and 9) at their end portions (2 and 3), substantially at the same places,

– a second step of depositing at least one layer of conducting material (5) over an entire first face (6) of the first of the substrates (4), with the openings (1) included,

– a third step of etching electrical connections (11) from the layer of conducting material (5), these connections being substantially parallel to one another

– a fourth step of fixing the second substrate (9) to the etched connections (11), with the openings (1) of the two substrates (4 and 9) being brought in coincidence, thus defining areas (110) wherein the connections (11) are rendered bare.

2. A method according to claim 1, characterized in that it further comprises:

- a first supplementary step implemented between the second and third step and consisting of depositing a layer of protective material (7) on a second face (8) of the first substrate opposing the first face (6) as well as in the openings (1) pierced in the substrate,

- a second supplementary step implemented between the third and fourth step and consisting of eliminating the layer of protective material (7) by means of a solvent.

3. A method according to any one of the preceding claims, characterized in that it comprises a step of tinning the areas (110) where the connections (11) are bare, which step is carried out after the fourth step.

4. A method according to one of the preceding claims and related to the use of three insulating substrates and of two layers of conducting material, characterized in that it comprises in addition the following steps:

- a fifth step of piercing openings (13) in the end portions of the third substrate (12) substantially at the same places as in the case of the two first substrates (4, 9),

- a sixth step of depositing a layer (14) of conducting material over an entire first face (5) of the third substrate (12),

- a seventh step of etching substantially parallel electrical connections (55) from the conducting layer (14),

- an eighth step of fixing the connections carried by the third substrate (12) to the second substrate (9), with the openings of the second and of the third substrate being brought into substantial coincidence.

5. A method according to claim 4, characterized in that it comprises in addition:

- a supplementary step implemented between the sixth and the seventh step and consisting of depositing a layer of protective material (16) on a second face (17) of the third substrate opposing the first one (15) as well as in the openings (13) pierced in that substrate,

- a supplementary step implemented between the seventh and the eighth step and consisting of eliminating the layer of protective material (16) by means of a solvent.

6. A method according to one of the claims 4 or 5, characterized in that it further comprises a step (18) of tinning the areas where the connections are rendered bare, which step is implemented before the eighth step.

7. A method according to the claims 1 and 4, characterized in that the connections (11) carried by the first substrate (4) are placed in parallel to one another, at a given pitch, and that the connections (55) carried by the third substrate are placed in parallel to one another at the same pitch as the preceding ones and disposed alternatively with the preceding ones.

8. A method according to any one of the preceding claims, characterized in that the electrical connections are constituted by parallel strips.

9. A method according to claim 8, characterized in that the parallel strips have a variable width (1) which decreases at the level of the openings (1).

10. A method according to claim 4, characterized in that the connections obtained by virtue of the seventh step are constituted by a conducting plane at the level of the insulating substrate (12) and by parallel strips at the level of the openings (13).

11. A device for electrically connecting two printed-circuit boards, comprising a first insulating substrate (4) having openings (1) and a layer of conducting material (5) fixed onto the first insulating substrate, said layer covering the openings (1), substantially parallel electrical connections (11) being cut in the layer of conducting material, characterized in that it further comprises a second insulating substrate (9) provided with openings at its two ends and disposed on the layer of conducting material, such that the openings of the two substrates substantially coincide with each other, thus defining the areas (110) wherein the connections (11) are rendered bare.

12. A device according to claim 11, characterized in that it further comprises a layer of preformed rigid material (24) deposited on one of the outer faces of the insulating substrate and intended to confer a predetermined shape to the device.

13. A device according to claim 11, characterized in that the insulating substrates are made of a polyimide.

14. A device according to claim 12, characterized in that the layer of preformed rigid material (24) is made of annealed copper.

15. A method for electrically connecting two printed circuit boards, each comprising a plurality of connection studs, by means of an electrical connection device according to one of claims 11 to 14, characterized in that it includes:

- a first step of bringing the studs (21) of the boards (19, 20) with the areas, wherein the connections (11) of the device are rendered bare,

- a second step of electrically connecting the connections with the studs by means of a brazing operation.

**Patentansprüche**

1. Verfahren zur Herstellung einer elektrischen Anschlußvorrichtung zwischen zwei Druckschaltungsplatten, das folgende Stufen aufweist:

- eine erste Stufe, in der Öffnungen (1) in mindestens zwei isolierenden Substraten (4 und 9) an deren beiden Enden (2 und 3) und im wesentlichen an den gleichen Stellen gebildet werden,

- eine zweite Stufe, in der mindestens eine Schicht aus leitendem Material (5) über eine ganze erste Fläche (6) des ersten der Substrate (4), einschließlich der Öffnungen (1) aufgebracht wird,

- eine dritte Stufe, in der durch Ätzen im wesentlichen parallele elektrische Anschlüsse (11) aus der Schicht des leitenden Materials (5) herausgearbeitet werden,

— eine vierte Stufe, in der das zweite Substrat (9) auf den geätzten Anschlüssen (11) befestigt wird, indem die Öffnungen (1) der beiden Substrate (4 und 9) im wesentlichen fluchten und somit Zonen (110) definieren, wo die Anschlüsse (11) blank zutagetreten.

2. Verfahren nach Anspruch 1, dadurch gekennzeichnet, daß es weiter aufweist:

— eine erste zwischen der zweiten und der dritten Stufe liegende zusätzliche Stufe, in der eine Schicht aus Schutzmaterial (7) auf eine zweite Fläche (8) des ersten Substrats gegenüber der ersten Fläche (6) sowie in den in diesem Substrat gebildeten Öffnungen (1) aufgebracht wird,

— eine zweite zwischen den dritten und der vierten Stufe liegende zusätzliche Stufe, in der Schutzmaterialschicht (7) durch ein Lösungsmittel entfernt wird.

3. Verfahren nach einem der vorhergehenden Ansprüche, dadurch gekennzeichnet, daß es weiter nach der vierten Stufe eine Stufe aufweist, in der die Zonen (110) verzinnt werden, in denen die Anschlüsse (11) blank sind.

4. Verfahren nach einem der vorhergehenden Ansprüche, ausgehend von drei isolierenden Substraten und zwei Schichten leitenden Materials, dadurch gekennzeichnet, daß es weiter die folgenden Stufen aufweist:

— eine fünfte Stufe, in der Öffnungen (13) an den Enden des dritten Substrates (12) im wesentlichen an den gleichen Stellen wie bei den beiden ersten Substraten (4, 9) gebildet werden,

— eine sechste Stufe, in der eine Schicht (14) aus leitendem Material auf eine ganze erste Fläche (5) des dritten Substrates (12) aufgebracht wird,

— eine siebte Stufe, in der im wesentlichen parallele elektrische Anschlüsse (55) aus der leitenden Schicht (14) durch Ätzen herausgearbeitet werden,

— eine achte Stufe, in der die vom dritten Substrat (12) getragenen Anschlüsse am zweiten Substrat (9) befestigt werden, wobei die Öffnungen des zweiten und dritten Substrats im wesentlichen fluchten.

5. Verfahren nach Anspruch 4, dadurch gekennzeichnet, daß es weiter aufweist:

— eine zusätzliche zwischen der sechsten und der siebten Stufe liegende Stufe, in der eine Schicht aus Schutzmaterial (16) auf eine zweite, der ersten Fläche (15) gegenüberliegende Fläche (17) des dritten Substrats (12) sowie in die in dieses Substrat eingebrachten Öffnungen aufgebracht wird,

— eine zusätzliche zwischen der siebten und der achten Stufe liegende Stufe, in der die Schutzmaterialschicht (16) durch ein Lösungsmittel entfernt wird.

6. Verfahren nach einem der Ansprüche 4 oder 5, dadurch gekennzeichnet, daß es weiter vor der achten Stufe eine Stufe (18) aufweist, in der die Zonen verzinnt werden, in denen die Anschlüsse blank liegen.

7. Verfahren nach den Ansprüchen 1 und 4, dadurch gekennzeichnet, daß die vom ersten Substrat (4) getragenen Anschlüsse (11) mit vorgegebenem Abstand parallel zueinander angeordnet sind, und daß die vom dritten Substrat getragenen Anschlüsse (55) im gleichen Abstand parallel zueinander wie die erstgenannten Anschlüsse und mit diesen alternierend angeordnet sind.

8. Verfahren nach einem der vorhergehenden Ansprüche, dadurch gekennzeichnet, daß die elektrischen Anschlüsse aus parallelen Streifen bestehen.

9. Verfahren nach Anspruch 8, dadurch gekennzeichnet, daß die parallelen Streifen eine variable Breite (8) besitzen, welche in Höhe der Öffnungen (1) abnimmt.

10. Verfahren nach Anspruch 4, dadurch gekennzeichnet, daß die in der siebten Stufe erhaltenen Anschlüsse aus einer leitenden Ebene in Höhe des isolierenden Substrat (12) und aus parallelen Bändern in Höhe der Öffnungen (13) bestehen.

11. Elektrische Anschlußvorrichtung zwischen zwei Druckschaltungsplatten, mit einem ersten isolierenden Substrat (4), das Öffnungen (1) und eine Schicht aus leitendem Material (5) aufweist, die auf dem ersten isolierenden Substrat befestigt ist und die Öffnungen (1) bedeckt, wobei im wesentlichen parallele elektrische Anschlüsse (11) aus der Schicht leitenden Materials ausgeschnitten sind, dadurch gekennzeichnet, daß sie weiter ein zweites isolierendes Substrat (9) mit Öffnungen an seinen Enden aufweist, welches auf der Schicht des leitenden Materials derart angeordnet ist, daß die Öffnungen der beiden Substrate im wesentlichen fluchten und somit die Zonen (110) definieren, in denen die Anschlüsse blank zutage treten.

12. Vorrichtung nach Anspruch 11, dadurch gekennzeichnet, daß sie weiter eine Schicht aus vorgeformtem steifem Material (24) aufweist, die auf eine der Außenflächen des isolierenden Substrats aufgebracht ist und dazu bestimmt ist, der Vorrichtung eine vorbestimmte Form zu verleihen.

13. Vorrichtung nach Anspruch 11, dadurch gekennzeichnet, daß die isolierenden Substrate aus einem Polyimid bestehen.

14. Vorrichtung nach Anspruch 12, dadurch gekennzeichnet, daß die Schicht aus vorgeformtem steifem Material (24) aus geglühtem Kupfer besteht.

15. Verfahren zum elektrischen Anschluß zwischen zwei Druckschaltungsplatten, von denen jede eine Vielzahl von Anschlußpunkten besitzt, mit Hilfe einer elektrischen Anschlußvorrichtung nach einem der Ansprüche 11 bis 14, dadurch gekennzeichnet, daß es aufweist:

— eine erste Stufe, in der die Anschlußpunkte (21) der Platten (19, 20) mit den Zonen, in denen die Anschlüsse (11) der Anschlußvorrichtung blank zutage treten, in Flucht gebracht werden,

— eine zweite Stufe, in der die Anschlüsse mit den Anschlußpunkten durch Verlöten in elektrische Verbindung gebracht werden.

# FIG_1

## FIG_2

## FIG_4

# FIG_3

# FIG_5

EP 0 163 581 B1